# EUROPEAN PATENT APPLICATION

(11) **EP 2 280 424 A2**
(43) Date of publication of application: **02.02.2011**
(21) Application number: 09171594.6
(22) Date of filing: 29.09.2009
(51) Int. Cl.: H01L 31/18, H01L 31/0224, H01L 23/544

(54) **Method of aligning a patterned electrode in a selective emitter structure of a solar cell**

(30) Priority: 20.07.2009 TW 98124408
(71) Applicant: E-Ton Solar Tech Co., Ltd., Tainan T'ai nan 70955 (TW)
(72) Inventor: Chen, Huai-Tsung, 70955, Tainan (TW)
(74) Representative: Becker Kurig Straus

(57) **Abstract**

A method of aligning a patterned electrode in a selective emitter structure of a solar cell is disclosed. A substrate (10) is provided. A barrier layer (12) is then formed on the substrate (10). The barrier layer (12) is patterned, and thus the substrate (10) is partially exposed to form a patterned electrode region (16). Thereafter, the surface property of the substrate (10) located in the patterned electrode region (16) is changed, so as to form a visible patterned mark (20). Subsequently, the barrier layer (12) is removed, and the visible patterned mark (20) is used as alignment mark.

## Description

The present invention relates to an aligning method of a patterned electrode in a selective emitter structure of a solar cell according to the pre-characterizing clause of claim 1.

The power generation efficiency of a solar cell (solar battery) is mainly decided by the photoelectric conversion efficiency, which may be improved based on modifying the following three factors. Firstly is improvement of light absorption ability. The free electron-hole pairs may be generated in the light absorption layer of solar cell when exposed under sunlight due to photovoltaic effect. When the solar cell has higher light absorption ability, more free electron-hole pairs may be generated, which therefore creates larger photo current. Secondly is reduction of recombination of electron-hole pairs. The recombination of electron-hole pairs causes loss of energy, and factors that cause the recombination include: the dangling bond existing between grain boundary and the internal defect in solar cell. Thirdly is reduction of contact resistance. The contact resistance between the metal electrode and the semiconductor layer of a solar cell may be reduced by virtue of forming heavy dopings, e.g. increasing dopants in the semiconductor layer. The heavy doping, however, will increase the probability of recombination of electron-hole pairs.

Currently, a selective diffusion technique to reduce the contact resistance has been developed in high efficiency solar cell industry to improve the photoelectric conversion efficiency. The method of selective diffusion is achieved by forming a selective emitter structure, which forms a patterned heavily doped region between the metal electrode and the semiconductor layer, but forms lightly doped regions in other areas of the semiconductor layer. Accordingly, the contact resistance can be reduced without increasing the probability of recombination of electron-hole pairs. In the conventional fabrication process of selective emitter structure, the location of the heavily doped region to be formed is defined by a mask pattern defined by photolithographic process, and the heavily doped region is then formed in the exposed region by diffusion techniques. The photolithographic process, nevertheless, is complex and expensive. In addition, the trouble of aligning still exists between the heavily doping region and the patterned electrode in the conventional fabrication process of the selective emitter structure. However, the photoelectric conversion efficiency of solar cell is adversely affected when the contact resistance rises due to inexact alignment between the heavily doped region and the patterned electrode.

This in mind, the present invention aims at providing a method of aligning a patterned electrode in a selective emitter structure of a solar cell that inexpensively reduces contact resistance with proper alignment between the heavily doping region and the patterned electrode.

This is achieved by providing a method of aligning a patterned electrode in a selective emitter structure of a solar cell according to claim 1. The dependent claims pertain to corresponding further developments and improvements.

As will be seen more clearly from the detailed description following below, the claimed method of aligning a patterned electrode in a selective emitter structure of a solar cell includes a changing a surface property of the substrate of the patterned electrode region to form a visible patterned mark and forming the patterned electrode on a surface of the substrate in the patterned electrode region according to the visible patterned mark as an alignment mark.

In the following, the invention is further illustrated by way of example, taking reference to the accompanying drawings. Thereof

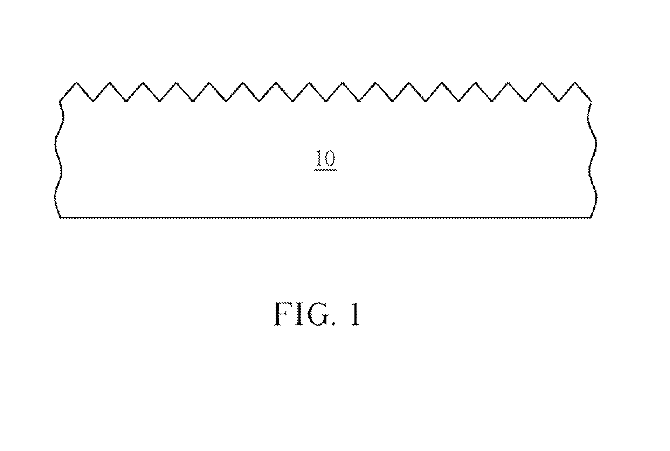

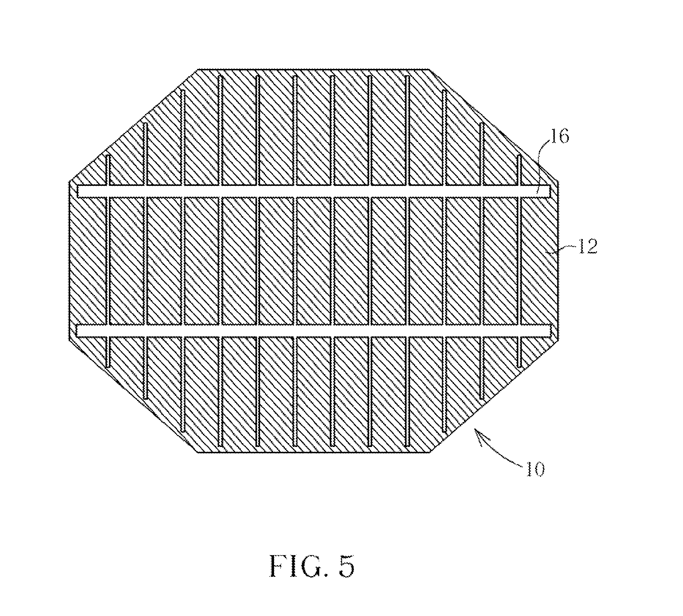

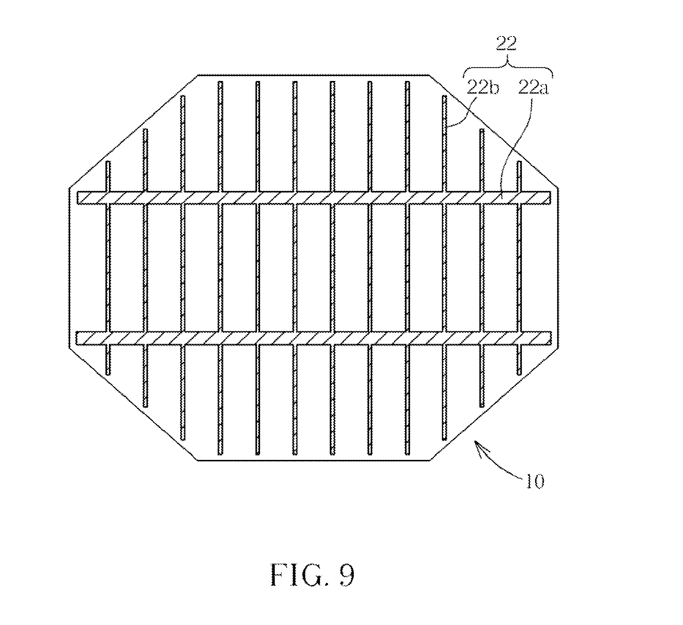

Figs. 1-9 are schematic diagrams illustrating a method of aligning a patterned electrode in a selective emitter structure of a solar cell in accordance with a preferred embodiment of the present invention.

To provide a better understanding of the presented invention, a preferred embodiment will be explained in details. The preferred embodiment of the present invention is illustrated in the accompanying drawings with numbered elements, but application of the present invention is not limited to the preferred embodiment.

Please refer to Figs. 1-9. Figs. 1-9 are schematic diagrams illustrating a method of aligning a patterned electrode in a selective emitter structure of a solar cell in accordance with a preferred embodiment of the present invention. To clearly illustrate the characteristic features of the present invention, Figs. 1-4 and Figs. 6-8 are cross-sectional views, while Figs. 5 and 9 are top views. In addition, the method of aligning a patterned electrode in a selective emitter structure of a solar cell is embodied to exemplarily elaborate the present invention, but application of the present invention is not limited to the preferred embodiment.

As shown in Fig. 1, a substrate 10 is provided. In this embodiment, the substrate 10 is a semiconductor layer. Then, a texturing treatment is carried out on the surface of the substrate 10. The textured surface reduces the reflection of incident light, and therefore the photoelectric conversion efficiency may be improved due to the increase of incident light beams.

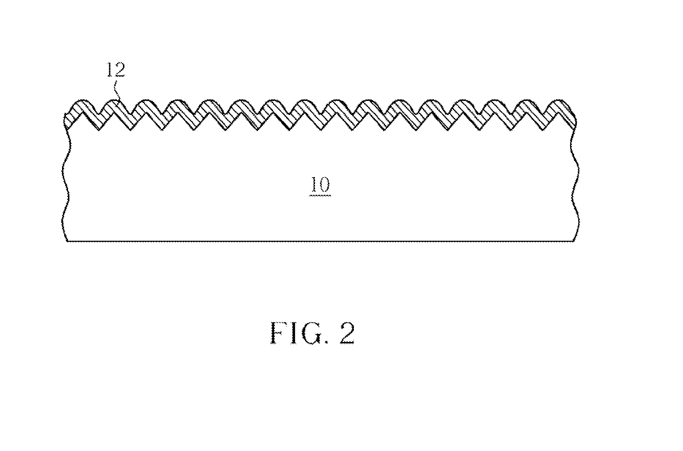

As shown in Fig. 2, a barrier layer 12 is formed on the substrate 10. Since the selective emitter structure of solar cell is used as an example in the present invention, the barrier layer 12 may be a diffusion barrier layer which may be formed by various thin film formation techniques.

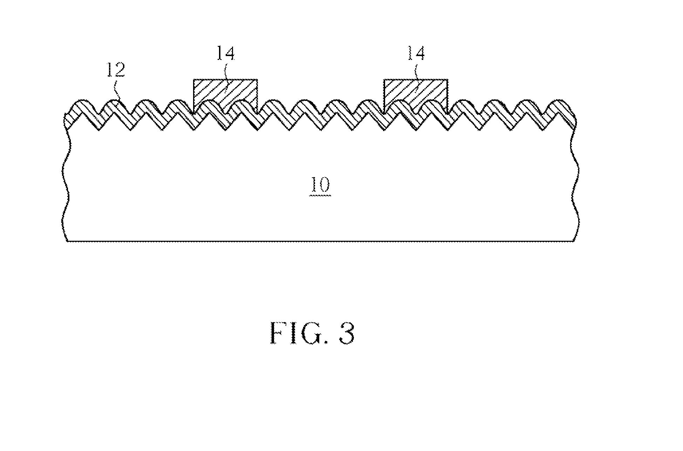

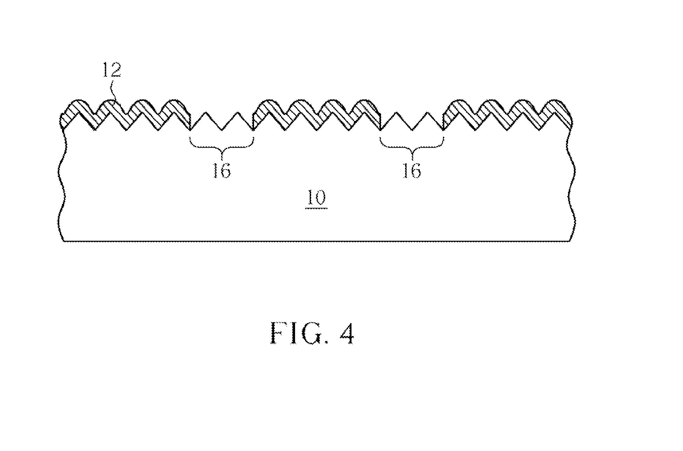

Subsequently, the barrier layer 12 is patterned to partially expose the surface of the substrate 10, which forms a pattern electrode region. In this embodiment, the method of patterning the barrier layer 12 includes the following steps. First, as shown in Fig. 3, a patterned etching material 14 is formed on the barrier layer 12 for defining the location of patterned electrode. The patterned etching material 14 selectively etches off part of the barrier layer 12 downwardly to partially expose the surface of the substrate 10. As shown in Figs. 4-5, the patterned etching material 14 is removed to expose the patterned electrode region 16 of the substrate 10.

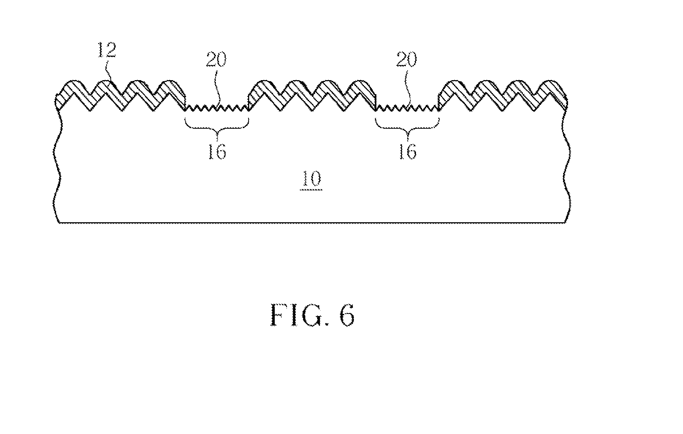

As shown in Fig. 6, the surface property of the substrate 10 in the patterned electrode region 16 is changed to form a visible patterned mark 20. In this embodiment, the surface property of the substrate 10 in the patterned electrode region 16 denotes the surface roughness of the substrate 10. By virtue of changing the surface roughness of the substrate 10 in the patterned electrode region 16, the optical reflectivity of the substrate 10 in the patterned electrode region 16 changes accordingly. In comparison with other regions of the substrate 10, the different optical reflectivity renders the patterned electrode region 16 a visible patterned mark 20, which may serve as an alignment mark. As illustrated in Fig. 6, the optical reflectivity of the substrate 10 in the patterned electrode region 16 is distinct from other regions of the substrate 10, and therefore the visible patterned mark 20 can be used as alignment mark. It is noted that the surface property is not limited to the surface roughness i.e. the optical reflectivity. Therefore, the visible patterned mark 20 may be formed by changing other surface property of the substrate 10 in the patterned electrode region 16.

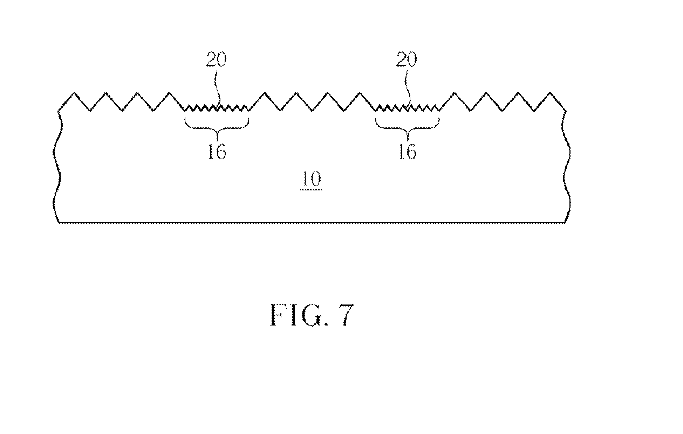

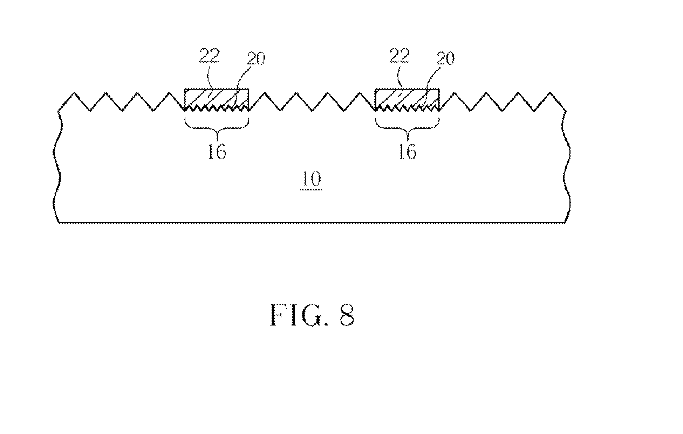

As shown in Fig. 7, the barrier layer 12 is then removed from the surface of the substrate 10. As shown in Figs. 8-9, the visible patterned mark 20 is used as alignment mark, and a patterned electrode 22 is formed on the patterned electrode region 16 of the substrate 10 by referring the visible patterned mark 20. In this embodiment, the patterned electrode 22 is formed by a screen printing process, but the application of the present invention is not limited to the preferred embodiment. In addition, the patterned electrode 22 includes bus bars 22a that have larger line width, and fingers 22b that have smaller line width, but the pattern of the patterned electrode 22 is not limited.

In summary, the aligning method of patterned electrode in a selective emitter structure of a solar cell forms a visible patterned mark on the surface of the substrate in the patterned electrode region in advance, and thus the patterned electrode formed subsequently can be precisely aligned by referring to the visible patterned mark as an alignment mark.

## Claims

1. A method of aligning a patterned electrode (22, 22a, 22b) in a selective emitter structure of a solar cell, comprising:
providing a substrate (10);
forming a barrier layer (12) on the substrate (10), and patterning the barrier layer (12) to
partially expose the substrate (10) to form a patterned electrode region (16);
changing a surface property of the substrate (10) of the patterned electrode region (16) to
form a visible patterned mark (20);
removing the barrier layer (12); and
forming the patterned electrode (22, 22a, 22b) on a surface of the substrate (10) in the
patterned electrode region (16) according to the visible patterned mark (20) as an alignment mark.

2. The method of claim 1, wherein patterning the barrier layer (12) comprises:
forming a patterned etching material (14) on the barrier layer (12);
using the patterned etching material (14) to selectively etch off part of the barrier layer (12)
to partially expose the substrate (10); and
removing the patterned etching material (14).

3. The method of claims 1 or 2 wherein changing the surface property of the substrate (10) of the patterned electrode region (16) comprises changing an optical reflectivity of the substrate (10) of the patterned electrode region (16).

4. The method of claims 1, 2, or 3 wherein the barrier layer (12) comprises a diffusion barrier layer.

5. The method of claims 1, 2, 3, or 4 further comprising performing a texturing treatment on the surface of the substrate (10).

6. The method of claims 1, 2, 3, 4, or 5 wherein the patterned electrode (22, 22a, 22b) is formed by a screen printing process.
